# EUROPÄISCHE PATENTSCHRIFT

(11) **EP 2 040 317 B1**
(45) Veröffentlichungstag und Bekanntmachung des Hinweises auf die Patenterteilung: **04.04.2018**
(21) Anmeldenummer: 08164755.4
(22) Anmeldetag: 22.09.2008
(51) Int. Cl.: H01L 51/54

(54) **Lösungsprozessiertes organisches elektronisches Bauelement mit verbesserter Elektrodenschicht**
Solution processed organic device having an improved electrode
Dispositif organique procédé par solution avec une électrode améliorée

(30) Priorität: 24.09.2007 DE 102007045518
(43) Veröffentlichungstag der Anmeldung: 25.03.2009
(73) Patentinhaber: Siemens Aktiengesellschaft, 80333 München (DE); OSRAM OLED GmbH, 93049 Regensburg (DE)
(72) Erfinder: Kanitz, Andreas, 91315, Höchstadt (DE); Suhonen, Riikka, 91054, Erlangen (DE); Pätzold, Ralph, 91154, Roth (DE); Sarfert, Wiebke, 91074, Herzogenaurach (DE)
(74) Vertreter: Epping - Hermann - Fischer

(56) Entgegenhaltungen:
- EP-A2- 1 369 937
- EP-A2- 1 369 938
- JP-A- 2003 303 681
- JP-A- 2004 335 137
- US-A- 5 965 281
- US-A1- 2003 209 707

## Beschreibung

Die Erfindung betrifft ein lösungsprozessiertes organisches elektronisches Bauelement mit einer verbesserten Elektrodenschicht.

In den letzten Jahren wurden organische elektronische Bauelemente, wie beispielsweise organische Photodetektoren, organische elektrochrome Geräte und/oder organische Leuchtdioden, die basierend auf sogenannten "Small Molecules" aufgebaut sind, besonders dadurch verbessert, dass sie n- und/oder p-dotierte organische Halbleiterschichten enthielten, die die Injektion der jeweiligen Ladungsträger erleichterten, d.h. beispielsweise, dass die OLEDs bei geringerer Betriebsspannung die gleiche Lumineszenz erreichen. Diese Technik ist beispielsweise aus der WO 2005086251 A2 bekannt.

Bei den aus Lösung prozessierten organischen elektronischen Bauelementen wie beispielsweise den polymeren OLEDs ist das Doping von Ladungsinjektionsschichten weitgehend unbekannt, da es schwierig ist, mehrere organische Materialien aus Lösung übereinander abzuscheiden ohne die darunterliegende Schicht/Schichten wieder ab- oder anzulösen.

Um eine gute Elektroneninjektion in den polymeren Schichten organischer elektronischer Bauteile zu gewährleisten, wird beispielsweise die Kathode mehrschichtig ausgeführt, besonders vorteilhaft aus Barium und Aluminium. Dabei wird das Barium auf Grund seiner geringen Austrittsarbeit als Elektronenquelle benutzt.

Der Nachteil der Technik ist, dass Barium stark oxidationsempfindlich, also instabil ist und Aluminium allein nicht als Kathodenmaterial eingesetzt werden kann, da es eine zu hohe Injektionsbarriere/Austrittsarbeit hat.

Dabei dient die Anwendung des Aluminiums in der Mehrschichtelektrode mit Barium nur für einen primären Oxidationsschutz bei der Abdeckung der oxidationsempfindlichen Bariumschicht.

Die Patentanmeldung US 2003/209707 A1 beschreibt eine organische elektrolumineszierende Vorrichtung, welche lichtdurchlässige Bereiche mit einem hohen Transmissionskoeffizienten aufweist und für Displays geeignet ist. Die Anmeldung beschreibt zudem eine Methode für die Herstellung derartiger organischer elektrolumineszierender Vorrichtungen mit hoher Ausbeute und ein Display, welches die organische elektrolumineszierende Vorrichtung umfasst.

EP 1 369 937 A2 beschreibt eine OLED Vorrichtung, umfassend ein Substrat, eine auf dem Substrat aus einem leitfähigen Material geformte Anode, eine auf der Anodenschicht aufgebrachte emittierende Schicht mit einem elektrolumineszierenden Material, eine auf der emittierenden Schicht aufgebrachte Pufferschicht mit einer Alkalimetallverbindung oder thermischen Zersetzungsprodukte derselben und eine auf der Pufferschicht aufgebrachte gesputterte Schicht eines Metalls oder einer Metalllegierung, die ausgewählt ist um zusammen mit der Pufferschicht Elektroneninjetion zu ermöglichen.

US 5,965,281 A offenbart, dass die Addition von hoch polarisierbaren Additiven, wie z.B. Lithium Nonylphenoxyether-sulfat, zu elektrisch aktiven Polymeren die elektrischen Eigenschaften des Polymers verbessert. JP2004335137 A offenbart ein organisches elektronisches Bauelement, das lösungsprozessierbar ist. Aufgabe der vorliegenden Erfindung ist es, eine Elektrode zur Injektion von Elektronen aus einer Metallschicht in die polymere aktive organische halbleitende Schicht des elektronischen Bauelements zur Verfügung zu stellen, was einem n-Doping entspricht.

Gegenstand der Erfindung ist ein lösungsprozessiertes organisches elektronisches Bauelement, ein Substrat, zumindest zwei ein- oder mehrschichtige Elektroden, dazwischen mindestens eine aktive organische halbleitende Schicht und zwischen einer Elektrodenschicht und einer aktiven organischen halbleitenden Schicht eine Zwischenschicht und/oder ein Interface umfassend, dadurch gekennzeichnet, dass ein Cäsiumsalz als n-Dopant in der Zwischenschicht/dem Interface enthalten ist.

Als Interface wird der schichtförmige Bereich zweier benachbarter Schichten bezeichnet, die nicht notwendiger Weise scharf abgegrenzt vorliegen, in dem, den Oberflächenbedingungen der jeweiligen Schichten entsprechend oder aus sonstigen Gründen die genaue Materialzusammensetzung, beispielsweise im Vergleich zur Schichtmitte oder zur gegenüberliegenden Schichtoberfläche, verändert ist. Beispielsweise wandern durch Anlegen von Spannung auf beiden Seiten einer mit Ladungsträgern versetzten Schicht die Ladungsträger mit positiver Ladung zu dem negativen Pol und die Ladungsträger mit negativer Ladung auf die gegenüberliegende Seite, wohingegen in der Schichtmitte ein gleiche Verteilung der Ladungsträger zu beobachten sein wird. Als Interface wird dann der Teil der Schicht bezeichnet, in dem ein Anstieg einer Art von Ladungsträger zu verzeichnen ist.

Allgemeine Formeln beispielhafter einfach und billig zugänglicher Cäsiumsalze, die gemäß der Erfindung eingesetzt werden, sind im Folgenden dargestellt:
polymer gebundener Carbonsäuren: 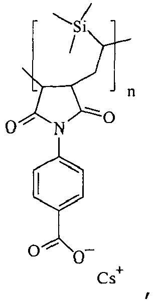 wobei n für beliebige kommerziell erhältliche Polymerisationsgrade der Prekursormaterialien steht.
Nicht beansprucht aber beschrieben werden allgemeine Formeln beispielhafter einfach und billig zugänglicher Cäsiumsalze, die im Folgenden dargestellt sind:
1) der Alkansulfonsäuren: 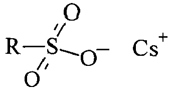
2) der Dicarbonsäuren: 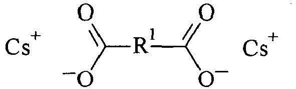
3) der Disulfonsäuren: 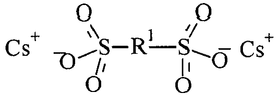
4) polymer gebundener Sulfonsäuren 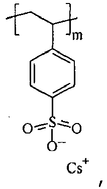 wobei R für Alkyl (C₁-C₂₀ normal, verzweigt, gesättigt oder ungesättigt und/oder hydroxysubstituiert), Phenyl (alkyliert und/oder hydroxy- und/oder alkoxy-substituiert) und/oder Pyridyl steht,
   R¹ für Alkylen (C₂-C₂₀ normal, verzweigt, gesättigt oder ungesättigt sowie hydroxysubstituiert), 1,2-Phenylen, 1,3-Phenylen 1,4-Phenylen oder 2,6-Pyridylen steht,
   m für beliebige natürliche Zahlen,
   kommerziell erhältliche Polymerisationsgrade der Prekursormaterialien steht, wobei unter Prekursormaterialien beispielsweise freie Organopolysäuren bzw. Organopolysulfonsäuren verstanden werden.

Nicht beansprucht aber beschrieben werden zudem die Cäsiumsalze der Monocarbonsäuren: 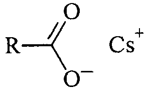 wobei R wie oben beschrieben definiert ist.

Als polymere organische elektronische Bauteile werden organische elektronische Bauteile bezeichnet, die lösungsprozessierte langkettige organische Schichten umfassen.

Die Eigenschaften der Materialien zur Eignung für Flüssigprozesse werden beispielsweise durch die Länge der Alkylgruppen erreicht. Ebenso können verschiedene Lösungsmittel eingesetzt werden.

Das halbleitende organische Material ist beispielsweise aus Lösung, aus bevorzugt polaren Lösungsmitteln applizierbar, je nach eingesetztem Cäsiumsalz auch aufdampfbar. Die Aufbringung findet bevorzugt über die bekannten Beschichtungsverfahren wie spin-coating, Besprühen, Sputtern etc. statt.

Zum Aufbau des elektronischen Bauteils wird auf einem Substrat eine untere, ein- oder mehrschichtige, Elektrode aufgebracht, darauf eine organische halbleitende und aktive Schicht und darauf schließlich eine Schicht, bei der die erfindungsgemäße Verwendung der Cäsiumsalze umgesetzt ist. Auf diese Zwischenschicht zur besseren Elektroneninjektion aus einer Metallelektrode wie beispielsweise einer Aluminiumelektrode wird die Elektrodenschicht aufgebracht.

Die Herstellung der Materialien geschieht durch Umsetzung der freien Säuren unter Erwärmung mit Cäsiumcarbonat in einem polaren Lösungsmittel (Butanol, Ethanol oder Acetonitril etc.)

Die Schichtdicke der Emissionsschicht ist abhängig vom Emittermaterial und typischerweise kleiner 15 nm, also im Bereich von 0,1 bis 15 nm, insbesondere kleiner 10 nm und besonders bevorzugt im Bereich 3 bis 5 nm.

Als Elektrodenschichten werden bevorzugt Metallelektrodenschichten eingesetzt wie beispielsweise Schichten aus Aluminium, Silber, Gold, Palladium, Chrom, Zink, Platin etc. sowie beliebige Legierungen davon.

Im Folgenden wird die Erfindung noch anhand von Ausführungsbeispielen näher erläutert:

### a) Darstellung von Cäsiumstearat als Vergleichsbeispiel:

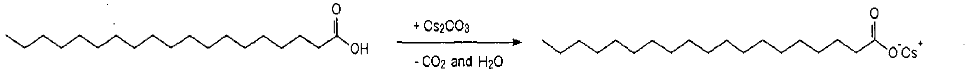

Eine Mischung von Cs₂CO₃ und Stearinsäure wird im Verhältnis 1:2 in Butanol vorgelegt und auf Rückfußtemperatur gehalten bis kein CO2 mehr gebildet wird. Danach wird Butanol am Rotationsverdampfer abgetrennt, der Rückstand mit Ether versetzt und abgesaugt, m.p.:263-269°C

### b) Darstellung von Dicäsiumsebazinat als Vergleichsbeispiel:

Eine Mischung von Cs₂CO₃ und Sebazinsäure wird im Verhältnis 1:1 in Butanol vorgelegt und auf Rückflusstemperatur
gehalten bis kein CO2 mehr gebildet wird. Danach wird Butanol am Rotationsverdampfer abgetrennt, der Rückstand mit Ether versetzt und abgesaugt.

### c) Darstellung des Cäsiumsalzes der Polystyrolsulfonsäure als Vergleichsbeispiel:

Eine Mischung von Cs₂CO₃ und Polystyrolsulfonsäure 20%-wässrige Lösung wird im Verhältnis 1:2 vorgelegt und kurz erwärmt bis kein CO2 mehr gebildet wird. Danach wird Butanol zugesetzt und das Wasser sowie das Butanol am Rotationsverdampfer abgetrennt, der Rückstand wird mit Ether versetzt und abgesaugt.

### d) Darstellung des Zäsiumsalz eines carbonsäurefunktionalisierten Polyimids:

### d1) Synthese der Copolymeren

### d1a) Radikalische Polymerisation

Unter absolut wasserfreien Bedingungen und unter einer sauerstofffreien Inertgasspülung werden 0,5 Mol Maleinsäureanhydrid und 0,5 Mol Trimethylallylsilan in 500 ml Dioxan gelöst und unter Zusatz von 2 Mol% AIBN (Azoisobuttersäurenitril) als Radikalstarter unter Rühren und Thermostatieren auf 50°C für 10h zur Reaktion gebracht. Im Anschluss daran wird das Lösungsmittel im Vakuum an einem Rotationsverdampfer vollständig entfernt. Tg : 200°C; Ausbeute quantitativ.

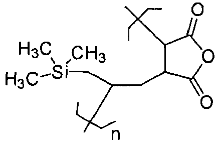

### D1b) imidisierende Kondensation

21,4g des nach Beispiel d1a erhaltenen Copolymer werden unter Rühren in 40ml Dimethylformamid gelöst und bei 50°C 2h erwärmt. Danach wird in Ethanol gefällt. Das gefällte Produkt wird bei 150°C in einem Trockenschrank getrocknet und dehydratisiert.

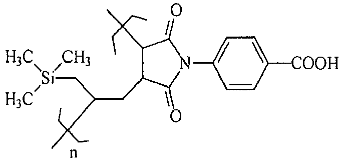

### d2) Synthese des Cäsiumsalzes:

Eine Mischung von Cs₂CO₃ und Poly[trimethylsilylallyl-co-N-(4-carboxyphenyl)-maleinsäureimid wird im Verhältnis 1:2 in Acetonitril vorgelegt und bei Rückflusstemperatur erwärmt bis kein CO2 mehr gebildet wird. Danach wird das Acetonitril am Rotationsverdampfer abgetrennt, der Rückstand wird mit Ether versetzt und abgesaugt.
e) Aufbau und Applikation der Schichten einer Polymer-OLED (Vergleich Stand der Technik, Cäsiumstearat durch Aufdampfen abgeschieden als Vergleichsbeispiel, Zäsiumstearat durch Spincoating als Vergleichsbeispiel abgeschieden):
   Beispielhafter Herstellungsprozess für das elektronische Bauteil:
      - Spincoating PEDOT:PSS 60-80nm auf ITO-Substrat (Glas)
      - Tempern der PEDOT-Schicht
      - Spincoating eines LEP (Licht emittierenden Polymer) 70-100nm
      - Spincoating der Organo-Cäsiumsalzschicht bzw. Aufdampfen der Bariumschicht
      - Aufdampfen der Aluminiumschicht

Die Figuren zeigen Device-Kennlinien, wie sie mit dem vorgestellten Beispiel erreicht wurden:
Die Struktur des Bauteils umfasste auf einem Substrat: ITO/PEDOT:PSS (60nm)/White Polymer (70nm)/CsSt/Al
   - Figur 1: zeigt die Strom-Spannungs-Kennlinie
   - Figur 2: zeigt die Lumineszenz-Kennlinie
   - Figur 3: zeigt die Effizienz-Kennlinien:
   - Figur 4: zeigt eine weitere Effizienz-Kennlinie.

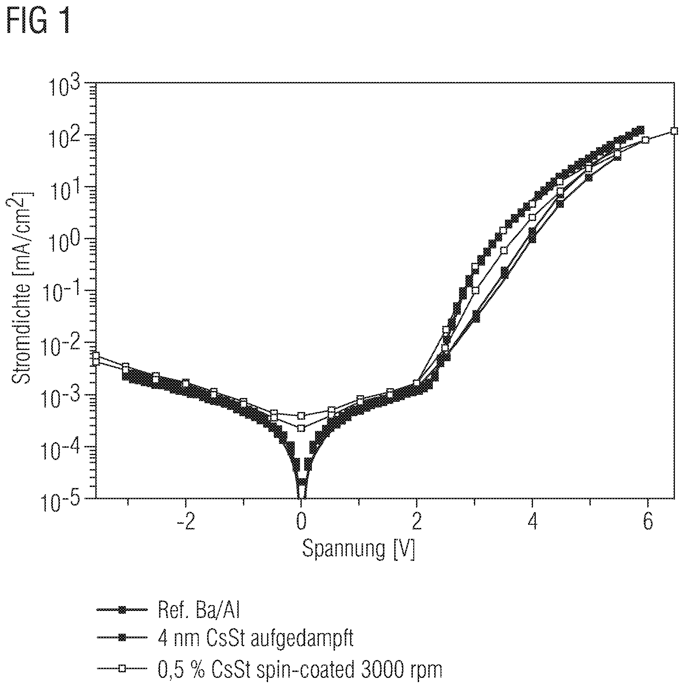

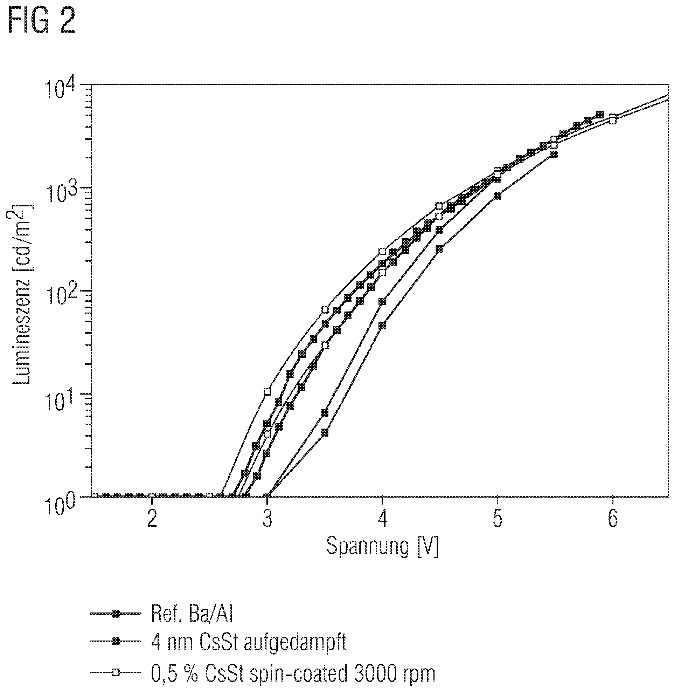

Wie in den Figuren 1 und 2 zu erkennen ist, fällt das Bauteil gegenüber der Referenz mit einer Barium-Aluminium-Elektrode in keiner Weise ab, sondern zeigt nahezu identische Strom-spannungs- und Lumineszenz-Werte.

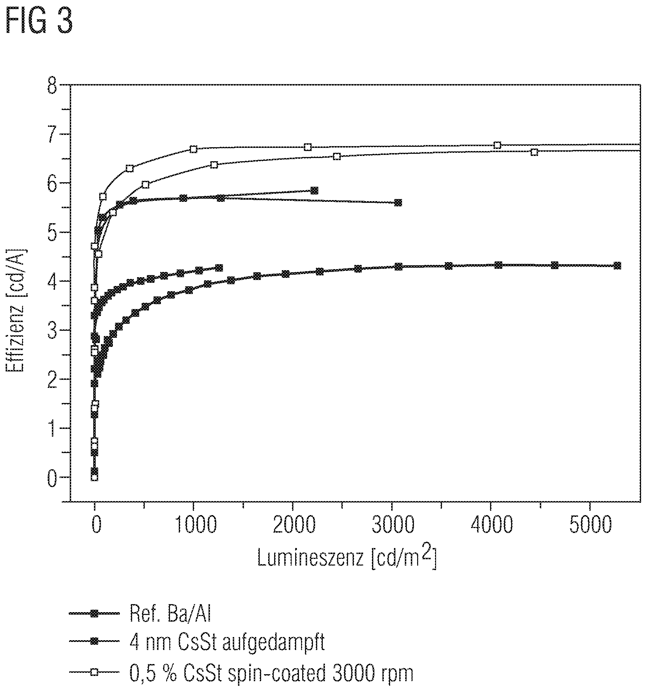

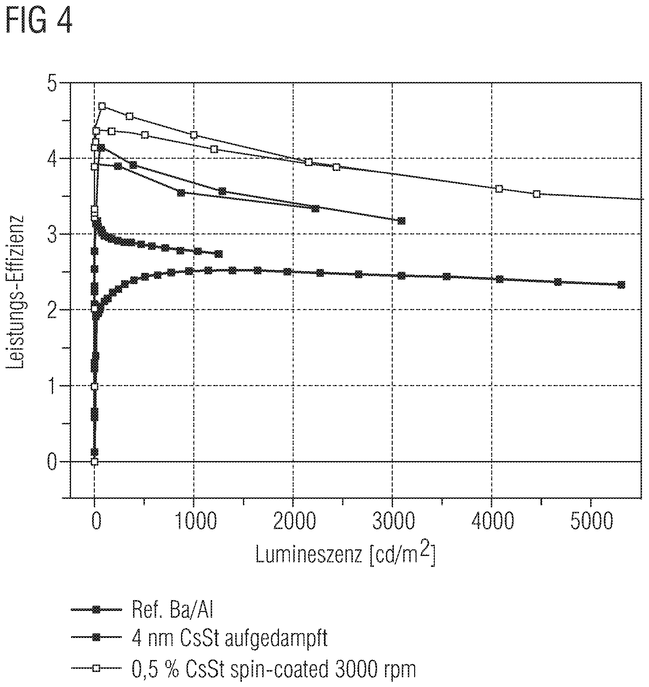

In Figuren 3 und 4 ist zu erkennen, dass die Art und Weise der Aufbringung der Cäsiumschicht doch einen erheblichen Einfluss auf die Effizienz des Bauteils haben kann.

Mit der Erfindung wird erstmals eine Alternative zur mehrschichtigen Elektrode unter Verwendung von Barium in organischen elektronischen Bauteilen eröffnet. Dabei wird eine Zwischenschicht aus zumindest einem Cäsiumsalz eingebaut, durch die es möglich ist, dass die Betriebsspannung und Lumineszenz des organischen Bauteils, also beispielsweise der OLED gegenüber der OLED mit Barium als Elektroneninjektionsschicht mindestens von gleicher Effektivität ist (siehe Figuren der Kennlinien).

Die Erfindung beschreibt die Verwendung eines Alkalimetallsalzes als n-Dotand zur Dotierung eines organischen halbleitenden Materials zur Veränderung der elektrischen Eigenschaften desselben, wobei das Alkalimetallsalz bezüglich der angrenzenden Materialien einen n-Dotanden darstellt.

Die Erfindung betrifft ein lösungsprozessiertes organisches elektronisches Bauelement mit einer verbesserten Elektrodenschicht. Zwischen der aktiven organischen Schicht und der Elektrodenschicht befindet sich entweder ein Interface oder ein Interlayer, also eine Zwischenschicht, in dem ein Cäsiumsalz enthalten ist.

## Patentansprüche

1. Lösungsprozessiertes organisches elektronisches Bauelement, ein Substrat, zumindest zwei ein- oder mehrschichtige Elektroden, dazwischen mindestens eine aktive organische halbleitende Schicht und zwischen einer Elektrodenschicht und einer aktiven organischen halbleitenden Schicht eine Zwischenschicht und/oder ein Interface umfassend, wobei ein Cäsiumsalz als n-Dopant in der Zwischenschicht/dem Interface enthalten ist, **dadurch gekennzeichnet, dass** das Cäsiumsalz ausgewählt ist aus zumindest einem Salz der folgenden polymer gebundenen Carbonsäuren: 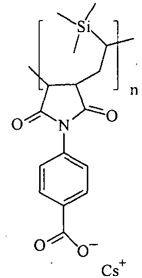 wobei n für beliebige kommerziell erhältliche Polymerisationsgrade der Prekursormaterialien steht.

2. Bauelement nach Anspruch 1, wobei die Zwischenschicht/das Interface, in der das Cäsiumsalz enthalten ist, eine Dicke im Bereich zwischen 0,1 nm und 15 nm hat.

3. Verfahren zur Herstellung eines lösungsprozessierten organischen elektronischen Bauelements umfassend die Verfahrensschritte:
- Aufbringen einer ersten ein- oder mehrschichtigen Elektrode auf ein Substrat,
- Aufbringen einer aktiven organischen halbleitenden Schicht,
- Aufbringen eines Cäsiumsalzes durch Spin-Coating zur Bildung einer Zwischenschicht und/oder eines Interface, wobei die Zwischenschicht und/oder das Interface das Cäsiumsalz als n-Dopant enthält,
- Aufbringen einer zweiten ein- oder mehrschichtigen Elektrode auf die Zwischenschicht und/oder das Interface,
**dadurch gekennzeichnet, dass** das Cäsiumsalz ausgewählt ist aus zumindest einem Salz der folgenden polymer gebundenen Carbonsäuren: 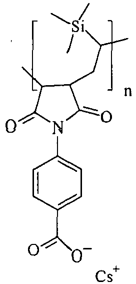 wobei
n für beliebige kommerziell erhältliche Polymerisationsgrade der Prekursormaterialien steht.

## Claims

1. A solution-processed organic electronic structural element comprising a substrate, at least two single-layer or multilayer electrodes, between them at least one active organic semiconductive layer and between an electrode layer and an active organic semiconductive layer an intermediate layer and/or an interface, wherein a cesium salt is contained as an n-dopant in the intermediate layer/the interface, **characterized in that** the cesium salt is selected from at least one salt of the following polymer-bound carboxylic acids: 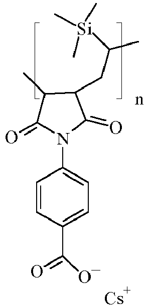 wherein n stands for any commercially available degree of polymerization of the precursor materials.

2. The structural element according to claim 1, wherein the intermediate layer/the interface containing the cesium salt has a thickness in the range between 0.1 nm and 15 nm.

3. A method of producing a solution-processed organic electronic structural element comprising the following steps:
- arranging a first single-layer or multilayer electrode on a substrate,
- arranging an active organic semiconductive layer,
- arranging a cesium salt via spin coating for forming an intermediate layer and/or an
interface, wherein the intermediate layer and/or the interface contains the cesium salt as an n-dopant,
- arranging a second single-layer or multilayer electrode on the intermediate layer and/or the interface, **characterized in that** the cesium salt is selected from at least one salt of the following polymer-bound carboxylic acids: 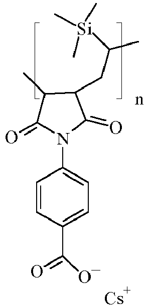
wherein n stands for any commercially available degree of polymerization of the precursor materials.

## Revendications

1. Composant électronique organique procédé par solution, comprenant un substrat, au moins deux électrodes monocouches ou multicouches, entre les deux au moins une couche semi-conductrice organique active, et entre une couche d'électrode et une couche semi-conductrice organique active, une couche intermédiaire et/ou une interface, un sel de césium étant contenu en tant que n-dopant dans la couche intermédiaire/l'interface, **caractérisé en ce que** ledit sel de césium est sélectionné parmi au moins un sel des acides carboxyliques liés à un polymère suivants : 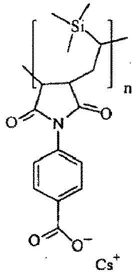 dans lequel n représente quelconques des degrés de polymérisation des matériaux précurseurs disponibles dans le commerce.

2. Composant selon la revendication 1, dans lequel la couche intermédiaire/l'interface dans laquelle est contenu le sel de césium, présente une épaisseur comprise entre 0,1 nm et 15 nm.

3. Procédé de production d'un composant électronique organique procédé par solution comprenant les étapes de procédé consistant à :
- appliquer une première électrode monocouche ou multicouche sur un substrat,
- appliquer une couche semi-conductrice organique active,
- appliquer un sel de césium par revêtement par centrifugation pour former une couche intermédiaire et/ou une interface, la couche intermédiaire et/ou l'interface contenant le sel de césium en tant que n-dopant,
- appliquer une seconde électrode monocouche ou multicouche sur la couche intermédiaire et/ou interface, **caractérisé en ce que** ledit sel de césium est sélectionné parmi au moins un sel des acides carboxyliques liés à un polymère suivants : 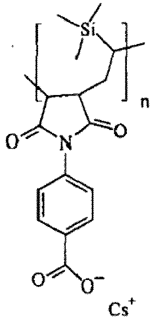
dans lequel
n représente quelconques des degrés de polymérisation des matériaux précurseurs disponibles dans le commerce.
